# EUROPEAN PATENT APPLICATION

(11) **EP 2 730 676 A1**
(43) Date of publication of application: **14.05.2014**
(21) Application number: 14154472.6
(22) Date of filing: 01.04.2011
(51) Int. Cl.: C23C 16/448, H01L 21/205, C23C 16/34, C23C 16/36, C23C 16/44, C23C 16/455

(54) **Method for deposition of silicon nitride layers**

(30) Priority: 01.04.2010 US 320236 P
(62) Divisional of application: 11763521.9
(71) Applicant: L'AIR LIQUIDE, SOCIETE ANONYME POUR L'ETUDE ET L'EXPLOITATION DES PROCEDES GEORGES CLAUDE, 75007 Paris (FR)
(72) Inventor: Higashino, Katsuko, Newark, DE 19702 (US); Yanagita, Kazutaka, Ibaraki, 300-3261 (JP)
(74) Representative: Grout de Beaufort, François-Xavier

(57) **Abstract**

Disclosed are methods for forming SiN-containing films from the combination of aminosilane precursors and chlorosilane precursors. Varying the sequential reaction of the aminosilane precursors and chlorosilane precursors provide for the formation of SiN-containing films having varying stoichiometry. In addition, the SiN-containing film composition may be modified based upon the structure of the aminosilane precursor. The disclosed processes may be thermal processes or plasma processes at low temperatures.

## Description

Disclosed are methods of forming metal-nitride-containing films from the combination of amino-metal precursors and halogenated metal precursors, preferably forming SiN-containing films from the combination of aminosilane precursors and chlorosilane precursors.

Varying the sequential reaction of the amino-metal precursors and halogenated metal precursors provide for the formation of metal-nitride-containing films having varying stoichiometry.

In addition, the metal-nitride-containing film composition may be modified based upon the structure of aminometal precursor. The disclosed processes may be thermal processes or plasma processes at low temperature.

Metal-nitride-containing films, such as silicon nitride (SiN) films, are widely used in semiconductor devices and ultra-large-scale integrated (ULSI) circuits. According to downsizing and the growing sophistication of electronic devices requiring increasingly higher LSI mounting densities, a SiN film is required to improve its film qualities against current leakage. In addition, SiCN film is also used as the etch stopper in a dual-damascene structure for Cu wiring.

Silicon nitride (SiN) films have been investigated to apply as etch stop/liner layer within a damascene at the back end of the line (BEOL) process. Within floating gate transistors, the inter-gate dielectric layer may comprise SiO₂ or SiN, for example. In addition, carbon doping the SiN layer provides high etch resistance.

As the size of large scale integrations (LSIs) is scaled down, film depth should be thinner requiring a more precisely controlled process, for example atomic layer deposition (ALD). In addition, a decrease in deposition temperature is required. ALD is widely used for many processes, for example SiO₂, SiN and metal films. See e.g., US Pat. No.7648927. However, the deposition rate tends to be lower than chemical vapor deposition (CVD). When the deposition temperature is lower, the deposition rate and the film quality of SiN have been worse.

Many articles have reported deposition of high quality SiN and SiCN films by using chlorosilane and activated NH₃ by PECVD, PEALD and introducing amine, CH₄ or C₂H₄ as a carbon source (see e.g., W02009/149167 and US2008/0213479).

A need remains for more precisely controlled processes to deposit metal-nitride-containing films.

Certain abbreviations, symbols, and terms are used throughout the following description and claims and include: the abbreviation "A" refers to Angstroms and 1 Angstrom = 100 picometers; the abbreviation "PECVD" refers to plasma enhanced chemical vapor deposition; the abbreviation "CVD" refers to chemical vapor deposition; the abbreviation "RF" refers to radiofrequency, the abbreviation "DR" refers to deposition rate, and the abbreviation "RI" refers to refractive index.

The term "alkyl group" refers to saturated functional groups containing exclusively carbon and hydrogen atoms. Further, the term "alkyl group" refers to linear, branched, or cyclic alkyl groups. Examples of linear alkyl groups include, without limitation, methyl groups, ethyl groups, propyl groups, butyl groups, etc. Examples of branched alkyl groups include, without limitation, t-butyl. Examples of cyclic alkyl groups include without limitation, cyclopropyl groups, cyclobutyl groups, cyclopentyl groups, cyclohexyl groups, etc.

As used herein, the abbreviation "Me" refers to a methyl group; the abbreviation "Et" refers to an ethyl group; the abbreviation "Pr" refers to a propyl group; the abbreviation "nPr" refers to a chain propyl group; the abbreviation "iPr" refers to an isopropyl group; the abbreviation "Bu" refers to a butyl (n-butyl) group; the abbreviation "tBu" refers to a tert-butyl group; the abbreviation "sBu" refers to a sec-butyl group; the abbreviation "iBu" refers to an iso-butyl group; and the abbreviation "TMS" refers to a trimethylsilyl group.

The standard abbreviations of the elements from the periodic table of elements are used herein. It should be understood that elements may be referred to by these abbreviations (e.g., Si refers to silicon, C refers to carbon, etc.).

Disclosed are methods of forming metal-nitride-containing films.

A halogenated metal precursor is introduced into an ALD reactor containing at least one substrate. Excess halogenated metal precursor is subsequently purged from the reactor. An amino-metal precursor is introduced into the reactor. Excess amino-metal precursor is subsequently from the reactor. A reactant may optionally be introduced into the reactor. Excess optional reactant is subsequently purged from the reactor. The metal of the halogenated metal precursor and the metal of the amino-metal precursor may be the same or different.

Also disclosed are methods of forming metal-nitride-containing films. A halogenated metal precursor is introduced into an ALD reactor containing at least one substrate. Excess halogenated metal precursor is subsequently purged from the reactor. An amino-metal precursor is introduced into the reactor. Excess amino-metal precursor is subsequently from the reactor. A reactant is introduced into the reactor. Excess reactant is subsequently purged from the reactor. The metal of the halogenated metal precursor and the metal of the amino-metal precursor may be the same or different.

Also disclosed are methods of forming silicon-nitride-containing films. A chlorosilane precursor is introduced into an ALD reactor containing at least one substrate. Excess chlorosilane precursor is subsequently purged from the reactor. An aminosilane precursor is introduced into the reactor. Excess aminosilane precursor is subsequently from the reactor. A reactant may optionally be introduced into the reactor. Excess optional reactant is subsequently purged from the reactor.

Also disclosed are methods of forming silicon-nitride-containing films. A chlorosilane precursor is introduced into an ALD reactor containing at least one substrate. Excess chlorosilane precursor is subsequently purged from the reactor.

An aminosilane precursor is introduced into the reactor. Excess aminosilane precursor is subsequently from the reactor. A reactant is introduced into the reactor. Excess reactant is subsequently purged from the reactor.

Each of the disclosed methods may further include one or more of the following aspects:
- the reactant being selected from the group consisting of N₂, NH₃, N₂H₄, NMeH₂, NEtH₂, NMe₂H, NEt₂H, NMe₃, NEt₃, MeHNNH₂, Me₂NNH₂, phenyl hydrazine, and mixtures thereof;
- the reactant being NH₃;
- producing metal-nitride-containing films having specified stoichiometry by varying the order of the method steps;
- the halogenated precursors being chlorometal precursors;
- the metal-nitride-containing film being a metal carbonitride film containing one or two metals;
- the metal being selected from transition metal, metal or non-metal elements;
- the metal being boron or phosphorus;
- the metal-nitride-containing film being a silicon-nitride-containing film;
- the halogenated metal precursor being a chlorosilane precursor;
- the amino-metal precursor being an aminosilane precursor;
- the silicon-nitride-containing film being carbon-doped SiN film;
- the chlorosilane precursor having the formula SiₐH_{b}Cl_{c}, wherein b+c = 2a+2;
- the chlorosilane precursors being introduced as a mixture;
- the aminosilane precursors having the formula H₄₋ₓSi(NR'R")ₓ, wherein x = 1, 2, 3, or 4, R' and R" are independently selected from H or an alkyl group, and R' and R" may be linked to form a ring structure;
- the aminosilane precursors comprising an aminochlorosilane or an aminoalkylsilane;
- the aminochlorosilane precursors having the formula Cl₄₋ₓSi(NR'R")ₓ, wherein x = 2 or 3, R' and R" are independently selected from H or an alkyl group, and R' and R" may be linked to form a ring structure; and
- the aminoalkylsilane precursors having a formula R"'₄₋ₓSi(NR'R")ₓ, wherein x = 1, 2, or 3, R' and R" are independently selected from H or an alkyl group, R' and R" may be linked to form a ring structure, and R'" group is an alkyl group having less than 3 carbons.

### Brief Description of the Drawings

For a further understanding of the nature and objects of the present invention, reference should be made to the following detailed description, taken in conjunction with the accompanying drawings, wherein:
**FIG 1** is a graph showing the deposition rate and refractive index of a SiCN film deposited using tris(dimethylamino)silane (3DMAS) and hexachlorodisilane (HCDS) according to the disclosed method versus the distance of the film from the inlet;
**FIG 2** is a graph showing the deposition rate and refractive index versus distance of a SiCN film deposited using 3DMAS and HCDS according to one alternative of the disclosed method;
**FIG 3** is a graph showing the deposition rate and refractive index versus distance of a SiCN film deposited using 3DMAS and HCDS according to a second alternative of the disclosed method;
**FIG 4** is a graph showing the deposition rate and refractive index of a SiCN film deposited using tetrakis(dimethylamino)silane (4DMAS) and hexachlorodisilane (HCDS) according to the disclosed method versus the distance of the film from the inlet;
**FIG 5** is a graph showing the deposition rate and refractive index versus distance of a SiCN film deposited using 4DMAS and HCDS according to one alternative of the disclosed method;
**FIG 6** is a graph showing the deposition rate and refractive index versus distance of a SiCN film deposited using 4DMAS and HCDS according to a second alternative of the disclosed method;
**FIG 7** is a graph showing the deposition rate and refractive index of a SiCN film deposited using bis(diethylamino)silane (BDEAS) and hexachlorodisilane (HCDS) according to the disclosed method versus the distance of the film from the inlet; and
**FIG 8** is a graph showing the deposition rate and refractive index versus distance of a SiCN film deposited using BDEAS and HCDS according to one alternative of the disclosed method.

### Detailed Description of Preferred Embodiments

Disclosed are ALD methods of forming metal-nitride-containing films using the alternate supply of amino-metal precursors and halogenated metal precursors.

The sequential reaction of the amino-metal precursors with the halogenated metal precursors produces a dense metal-rich film. The metal of the halogenated metal precursor may be the same as or different from the metal of the amino-metal precursor.

Also disclosed are ALD methods of forming silicon-nitride-containing films, preferably silicon carbonitride films, using the alternate supply of aminosilane precursors and chlorosilane precursors under thermal conditions or low temperature plasma conditions. The sequential reaction of the aminosilane precursors with the chlorosilane precursors produces a dense silicon-rich film at temperatures lower than those of many prior art silicon nitride film deposition processes.

The silicon carbonitride films may alternatively be referred to as carbon-doped silicon-nitride films. One of ordinary skill in the art will recognize that the level of carbon in the silicon-nitride film determines the appropriate nomenclature, with the amount of carbon in carbon-doped silicon nitride films typically being less than the amount of carbon in silicon carbonitride films. However, one of ordinary skill in the art will further recognize that the exact percentage of carbon in the film which determines the appropriate nomenclature is not defined and will vary from person to person.

The disclosed methods form metal-nitride-containing films, such as SiN, or a metal carbonitride films, such as SiCN, from amino-metal and halogenated metal precursors by ALD. The metal-nitride-containing film may be a metal carbonitride film containing one or two metals. For example, the metal carbonitride film may be a SiHfCN film. Alternatively, the SiN film may be carbon-doped.

As will be described in further detail in Examples 2-4, metal-nitride-containing films having specified stoichiometry may be produced by varying the order of the disclosed method steps. Furthermore, the duration of the disclosed method steps may also be varied in order to "tune" the resulting film.

The halogenated metal precursors are introduced into an ALD reactor containing one or more substrates. The halogenated metal precursors may be introduced into the ALD reactor before or after the amino-metal precursor. The conditions within the reactor permit at least part of the halogenated metal precursors to self adsorb on the substrates. One of ordinary skill in the art will recognize that the substrate properties will define whether the halogenated metal precursor undergoes physiadsorption or chemisorption in this step.

For example, if the halogenated metal precursors are introduced into the reactor after the amino-metal precursors, at least part of the halogenated metal precursors will react/chemisorp with the portion of the amino-metal precursors deposited in the prior step. Any non-adsorbed or "excess" halogenated metal precursor is purged out of the reactor. The halogenated metal precursors are reactive with NH₃/amino-metal precursors at low temperature.

The halogenated metal precursors may be chlorometal precursors. The metal of the halogenated metal or chlorometal precursors may be any transition metal, metal, or non-metal elements as commonly defined on the periodic table of elements. Preferred transition metals include but are not limited to Hf. Preferred metals include but are not limited to Zn.

Preferred non-metals include but are not limited to B, Si, and P. The halogenated metal precursor may be applied as a mixture of two or more halogenated metal precursors. Preferably, the halogenated metal precursors are chlorosilane precursors. Exemplary chlorosilane precursors have the formula SiₐH_{b}Cl_{c}, wherein b+c = 2a+2. Exemplary chlorosilane precursors include hexachlorodisilane (HCDS), SiCl₄, SiHCl₃, Si₂H₅Cl, etc., and mixtures thereof, such as HCDS and SiCl₄ or HCDS and SiHCl₃. Preferably, the halogenated metal precursor comprises HfCl₄ or HCDS, and more preferably HCDS.

The amino-metal precursors are introduced into the reactor. The conditions within the reactor permit at least part of the amino-metal precursors to self adsorb on the substrates. The amino-metal precursors may be introduced into the ALD reactor before or after the halogenated metal precursors. Once again, one of ordinary skill in the art will recognize that the substrate properties will define whether the amino-metal precursor undergoes physiadsorption or chemisorption in this step.

For example, if the amino-metal precursors are introduced into the reactor after the halogenated metal precursors, at least part of the amino-metal precursors will react/chemisorp with the portion of the halogenated metal precursors deposited in the prior step. Any non-adsorbed or "excess" amino-metal precursor is then purged out of the reactor. The amino-metal precursors may act as both a C-source and N-source, as opposed to the prior art NH₃ precursors which only act as a N-source. The alkylamino groups of the aminometal precursors serve as good leaving groups and lead to good adsorption. Varying the ligands of the aminometal precursors provides the ability to modify the carbon content of the metal-nitride-containing film.

The metal of the amino-metal precursors may be any transition metal, metal, or non-metal elements as commonly defined on the periodic table of elements. Preferred transition metals include but are not limited to Hf. Preferred metals include but are not limited to Zn. Preferred non-metals include but are not limited to B, Si, and P. The amino-metal precursor may be applied as a mixture of two or more amino-metal precursors. The amino-metal precursor may be aminosilane precursors. Exemplary aminosilane precursors have the formula H₄₋ₓSi(NR'R")ₓ, wherein x = 1, 2, 3, or 4, R' and R" are independently selected from H or an alkyl group, and R' and R" may be linked to form a ring structure. Alternatively, the aminosilane precursor may be an aminochlorosilane precursor or an aminoalkylsilane precursor.

Exemplary aminochlorosilane precursors have the formula Cl₄₋ₓSi(NR'R")ₓ, wherein x = 2 or 3, and R' and R" are as previously defined. Exemplary aminoalkylsilane precursors have the formula R"'₄₋ₓSi(NR'R")ₓ wherein x = 1, 2, or 3, R' and R" are as previously defined, and R'" group is an alkyl group having less than 3 carbons. Preferably, the amino-metal precursor is bis(diethylamino)silane (BDEAS), tris(dimethylamino)silane (3DMAS), tetrakis(dimethylamino) silane (4DMAS), or tetrakis(ethylmethylamino)hafnium, and more preferably 3DMAS and/or 4DMAS.

The halogenated metal precursors and aminometal precursors (collectively, the "precursors") are each individually introduced into the reactor in vapor form. In this context, "individually" and "each" refers to the specified class of precursors, for example "the halogenated metal precursors", which may consist of one or more halogenated precursors.

In the following paragraphs, individually is not intended to mean that the vapors of only one halogenated metal precursor are introduced into the reactor.

The precursors may be individually fed in liquid state to a vaporizer where they are each individually vaporized before introduction into the reactor. Prior to vaporization, each of the precursors may optionally be mixed with one or more solvents. The solvents may be selected from the group consisting of toluene, ethyl benzene, xylene, mesitylene, decane, dodecane, octane, hexane, pentane, or others. The resulting concentration may range from approximately 0.05 M to approximately 2 M.

Alternatively, the precursors may be individually vaporized by passing a carrier gas into a container containing each of the precursors or by bubbling the carrier gas into each of the precursors.

Each of the precursors may optionally be mixed in the container with one or more solvents. The carrier gas and individual precursors are then introduced into the reactor as a vapor. The carrier gas may include, but is not limited to, Ar, He, N₂, and mixtures thereof. Bubbling with a carrier gas may also remove any dissolved oxygen present in the precursors' solution.

If necessary, the container may be heated to a temperature that permits the precursors to be in liquid phase and to have a sufficient vapor pressure. The container may be maintained at temperatures in the range of, for example, 0°C to 150°C. Those skilled in the art recognize that the temperature of the container may be adjusted in a known manner to control the amount of precursor vaporized.

The vapor of each precursor may be introduced into the reactor for a time period ranging from approximately 0.01 seconds to approximately 60 seconds, alternatively from approximately 5 seconds to approximately 25 seconds, alternatively from approximately 10 seconds to approximately 20 seconds.

In one embodiment, a reactant may be introduced into the reactor, where it reacts with the self adsorbed layers on the substrates. Any non-reacted or "excess" reactant is then purged out of the reactor. The reactant may be N₂, NH₃, N₂H₄, NMeH₂, NEtH₂, NMe₂H, NEt₂H, NMe₃, NEt₃, MeHNNH₂, Me₂NNH₂, phenyl hydrazine, and mixtures thereof. Preferably, the reactant is NH₃.

However, as will be described in further detail in the Examples that follow, inclusion of the optional reactant steps will depend upon the desired stoichiometric ratio of elements in the resulting metal-nitride-containing film.

The reactant may be treated by plasma in order to decompose the reactant into its radical form. The plasma may be generated or present within the reactor itself. Alternatively, the plasma may generally be at a location removed from the reactor, for instance, in a remotely located plasma system. One of skill in the art will recognize methods and apparatus suitable for such plasma treatment.

For example, the reactant may be introduced into a direct plasma reactor, which generates a plasma in the reactor, to produce the plasma-treated reactant in the reactor. Exemplary direct plasma reactors include the Titan™ PECVD System produced by Trion Technologies. The reactant may be introduced and held in the reactor prior to plasma processing. Alternatively, the plasma processing may occur simultaneously with the introduction of reactant. In-situ plasma is typically a 13.56 MHz RF capacitively coupled plasma that is generated between the showerhead and the substrate holder. The substrate or the showerhead may be the powered electrode depending on whether positive ion impact occurs. Typical applied powers in in-situ plasma generators are from approximately 100 W to approximately 1000 W. The disassociation of the reactant using in-situ plasma is typically less than achieved using a remote plasma source for the same power input and is therefore not as efficient in reactant disassociation as a remote plasma system, which may be beneficial for the deposition of metal-nitride-containing films on substrates easily damaged by plasma.

Alternatively, the plasma-treated reactant may be produced outside of the reactor. The MKS Instruments' ASTRON^{®}i reactive gas generator may be used to treat the reactant prior to passage into the reactor. Operated at 2.45 GHz, 7kW plasma power, and a pressure ranging from approximately 3 Torr to approximately 10 Torr, the reactant NF₃ may be decomposed into three F⁻ radicals with more than 96% decomposing efficiency. Preferably, the remote plasma may be generated with a power ranging from about 1 kW to about 10 kW, more preferably from about 2.5 kW to about 7.5 kW.

The ALD reactor may be a heated vessel which has at least one or more substrates disposed within it. The reactor has an outlet which may be connected to a vacuum pump to allow by-products to be removed from the reactor, or to allow the pressure within the reactor to be modified or regulated.

Examples of suitable ALD reactors include, without limitation, a parallel-plate type reactor, a cold-wall type reactor, a hot-wall type reactor, a single-wafer reactor, a multi-wafer reactor, a direct plasma reactor, or other types of deposition systems under conditions suitable to cause the precursors to react and form the layers.

Generally, the reactor contains one or more substrates onto which the metal-nitride-containing films will be deposited. For example, the reactor may contain from 1 to 200 silicon wafers having from 25.4 mm to 450 mm diameters. The substrates may be any suitable substrate used in semiconductor, photovoltaic, flat panel, or LCD-TFT device manufacturing.

The substrates may contain one or more additional layers of materials, which may be present from a previous manufacturing step. Dielectric and conductive layers are examples of these. Within the scope of this application, all of the substrate and any layers deposited on the substrate are collectively included within the term substrate.

Examples of suitable substrates include without limitation, metal substrates, metal nitride substrates, silicon substrates, silica substrates, silicon nitride substrates, silicon oxynitride substrates, tungsten substrates, and combinations thereof. Additionally, substrates comprising tungsten or noble metals (e.g. platinum, palladium, rhodium, or gold) may be used. Preferably, the substrate is a metal film or metal nitride film.

The temperature of the reactor may be controlled by either controlling the temperature of the substrate holder or controlling the temperature of the reactor wall.

Devices used to heat the substrate are known in the art. The reactor is heated to a sufficient temperature to obtain the desired metal-nitride-containing film at a sufficient growth rate and with desired physical state and composition. A non-limiting exemplary temperature range to which the reactor may be heated includes from approximately 200°C to approximately 700°C.

When a plasma deposition process is utilized, the deposition temperature may range from approximately 200°C to approximately 550°C.

Alternatively, when a thermal process is performed, the deposition temperature may range from approximately 400°C to approximately 600°C.

The pressure in the ALD reactor is approximately 0.1 Torr (13 Pa) to approximately 10 Torr (1300 Pa).

In one preferred embodiment, the disclosed methods utilize chlorosilane precursors, preferably HfCl₄ or HCDS, and aminosilane precursors, preferably 3DMAS, 4DMAS, or tetrakis(ethylmethylamino) hafnium, to form SiN-containing or SiCN-containing films. The films formed have very low (from approximately 0 to approximately 5 atomic %) chlorine or oxygen content.

The disclosed methods solve the problem about the film quality of SiN-containing films by atomic layer deposition at low temperature, and C insertion in SiN-containing films.

The disclosed methods provide the following advantages over the existing methods:
- Carbon insertion into SiN film with tunable combination of aminosilane and chlorosilane

The reasons are:
- A ratio change in the combination makes different composition films.

### Examples

The following non-limiting examples are provided to further illustrate embodiments of the invention. However, the examples are not intended to be all inclusive and are not intended to limit the scope of the inventions described herein.

### Example 1

A dense SiCN film was deposited using an ALD method and trichlorosilane (3CS) and tris(dimethylamino)silane (3DMAS) precursors. The reaction chamber was controlled at 5 Torr, 550°C, and 100 sccm of Ar was continuously flowing.

The deposition process consisted of the following steps of: 1) supplying a pulse of approx.1 sccm of 3CS to the reaction chamber for 10 seconds, 2) purging the 3CS precursor with 100 sccm of Ar for 30 seconds, 3) supplying a pulse of approx.1 sccm of 3DMAS to the reaction chamber for 10 seconds, 4) purging the 3DMAS precursors with 100 sccm of Ar for 30 seconds. Sequences 1) through 4) were repeated until the deposited layer achieves suitable layer thickness.

The deposited film shows that the deposition rate is around 0.6A/cycle. The refractive index is above 2.1.

### Example 2a

A dense SiCN film was deposited using an ALD method with hexachlorodisilane (HCDS) and tris(dimethylamino)silane (3DMAS) precursors and an ammonia (NH₃) reactant. The reaction chamber was controlled at 5 Torr, 550°C, and 55 sccm of Ar was continuously flowing. The deposition process comprised the following steps of: 1) introducing a pulse of approx.1 sccm of 3DMAS into the reaction chamber for 10 seconds, 2) purging the 3DMAS precursor with 55 sccm of Ar for 30 seconds, 3) introducing a pulse of approx.1 sccm of HCDS into the reaction chamber for 10 seconds, 4) purging the HCDS precursor with 55 sccm of Ar for 30 seconds, 5) introducing a pulse of approx. 50 sccm of NH₃ into the reaction chamber for 10 seconds, and 6) purging the NH₃ reactant with 55 sccm of Ar for 10 seconds. Sequences 1) through 6) were repeated until the deposited layer achieved suitable layer thickness.

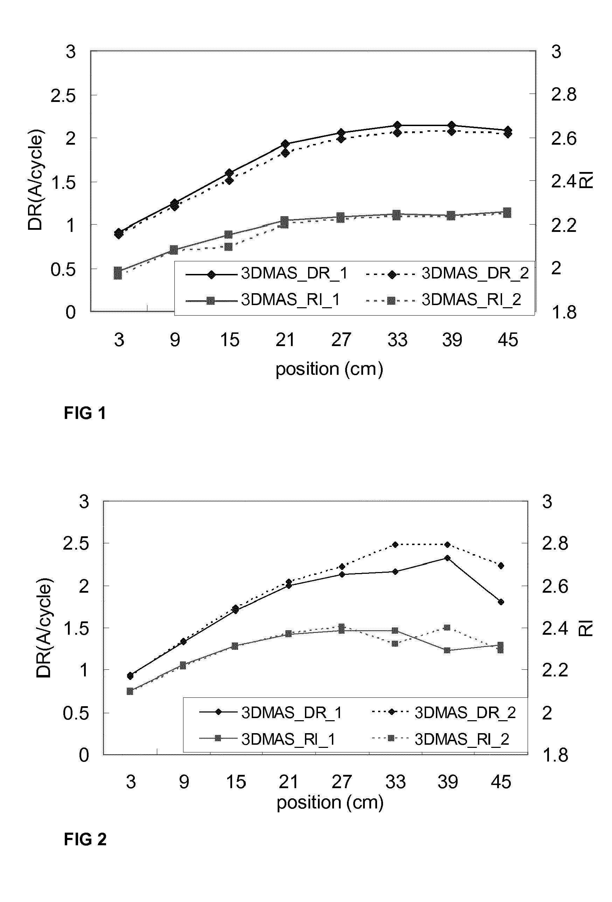

The deposition rate and the refractive index of the deposited film are shown in **FIG 1****.** The atomic composition percentage of silicon and nitrogen in the resulting film was greater than 40% but less than 45% for each, with an atomic composition percentage of approximately 10% for the carbon. The atomic composition percentage of chlorine and oxygen in the resulting film was 0% or greater but less than 5% for each. The wet etch rate of the resulting film by a HF solution was 4.24 A/min.

### Example 2b

A dense SiCN film was deposited using an ALD method with HCDS 3DMAS precursors and an ammonia (NH₃) reactant. The reaction chamber was controlled at 5 Torr, 550°C, and 55 sccm of Ar was continuously flowing. The deposition process comprised the following steps of: 1) introducing a pulse of approx.1 sccm of HCDS into the reaction chamber for 10 seconds, 2) purging the HCDS precursor with 55 sccm of Ar for 30 seconds, 3) introducing a pulse of approx.1 sccm of 3DMAS into the reaction chamber for 10 seconds, 4) purging the 3DMAS precursor with 55 sccm of Ar for 30 seconds, 5) introducing a pulse of approx. 50 sccm of NH₃ into the reaction chamber for 10 seconds, and 6) purging the NH₃ reactant with 55 sccm of Ar for 10 seconds. Sequences 1) through 6) were repeated until the deposited layer achieved suitable layer thickness.

The deposition rate and the refractive index of the deposited film are shown in **FIG 2****.** The atomic composition percentage of silicon in the resulting film was greater than 45% but less than 50%, the atomic composition percentage of nitrogen in the resulting film was greater than 30% but less than 35%, and the atomic composition percentage of carbon was greater than 15% but less than 20%. The atomic composition percentage of chlorine and oxygen in the resulting film was 0% or greater but less than 5% for each. The wet etch rate of the resulting film by a HF solution was 0.54 A/min.

### Example 2c

A dense SiCN film was deposited using an ALD method with HCDS and 3DMAS precursors. The reaction chamber was controlled at 5 Torr, 550°C, and 55 sccm of Ar was continuously flowing. The deposition process comprised the following steps of: 1) introducing a pulse of approx.1 sccm of 3DMAS into the reaction chamber for 10 seconds, 2) purging the 3DMAS precursor with 55 sccm of Ar for 30 seconds, 3) introducing a pulse of approx.1 sccm of HCDS into the reaction chamber for 10 seconds, and 4) purging the HCDS precursor with 55 sccm of Ar for 30 seconds. Sequences 1) through 4) were repeated until the deposited layer achieved suitable layer thickness.

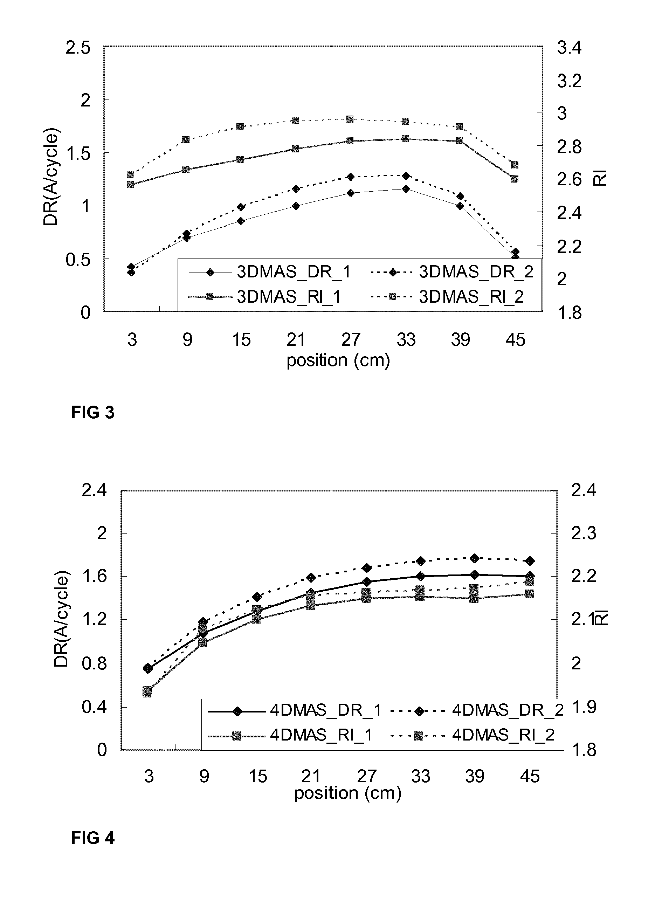

The deposition rate and the refractive index of the deposited film are shown in **FIG 3****.** The atomic composition percentage of silicon in the resulting film was greater than 50% but less than 55%, the atomic composition percentage of carbon in the resulting film was greater than 30% but less than 35%, and the atomic composition percentage of nitrogen was approximately 10%. The atomic composition percentage of chlorine and oxygen in the resulting film was 1% or greater but less than 5% for each. The wet etch rate of the resulting film by a HF solution was 0.04 A/min.

### Example 3a

A dense SiCN film was deposited using an ALD method with hexachlorodisilane (HCDS) and tetrakis(dimethylamino)silane (4DMAS) precursors and an ammonia (NH₃) reactant. The reaction chamber was controlled at 5 Torr, 550°C, and 55 sccm of Ar was continuously flowing.

The deposition process comprised the following steps of: 1) introducing a pulse of approx.1 sccm of 4DMAS into the reaction chamber for 10 seconds, 2) purging the 4DMAS precursor with 55 sccm of Ar for 30 seconds, 3) introducing a pulse of approx.1 sccm of HCDS into the reaction chamber for 10 seconds, 4) purging the HCDS precursor with 55 sccm of Ar for 30 seconds, 5) introducing a pulse of approx. 50 sccm of NH₃ into the reaction chamber for 10 seconds, and 6) purging the NH₃ reactant with 55 sccm of Ar for 10 seconds. Sequences 1) through 6) were repeated until the deposited layer achieved suitable layer thickness.

The deposition rate and the refractive index of the deposited film are shown in **FIG 4****.** The atomic composition percentage of nitrogen in the resulting film was approximately 45%, the atomic composition percentage of silicon in the resulting film was greater than 40% but less than 45%, and the atomic composition percentage of carbon was greater than 5% but less than 10%.

The atomic composition percentage of chlorine and oxygen in the resulting film was 0% or greater but less than 5% for each. The wet etch rate of the resulting film by a HF solution was 5.76 A/min.

### Example 3b

A dense SiCN film was deposited using an ALD method with HCDS and 4DMAS precursors and an ammonia (NH₃) reactant. The reaction chamber was controlled at 5 Torr, 550°C, and 55 sccm of Ar was continuously flowing. The deposition process comprised the following steps of: 1) introducing a pulse of approx.1 sccm of HCDS into the reaction chamber for 10 seconds, 2) purging the HCDS precursor with 55 sccm of Ar for 30 seconds, 3) introducing a pulse of approx.1 sccm of 4DMAS into the reaction chamber for 10 seconds, 4) purging the 4DMAS precursor with 55 sccm of Ar for 30 seconds, 5) introducing a pulse of approx. 50 sccm of NH₃ into the reaction chamber for 10 seconds, and 6) purging the NH₃ reactant with 55 sccm of Ar for 10 seconds. Sequences 1) through 6) were repeated until the deposited layer achieved suitable layer thickness.

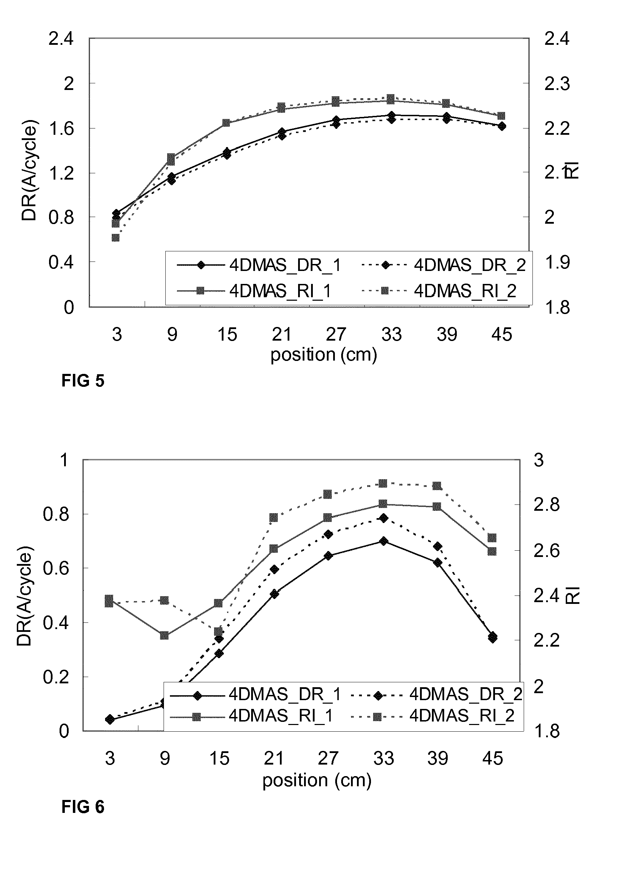

The deposition rate and the refractive index of the deposited film are shown in **FIG 5****.** The atomic composition percentage of silicon in the resulting film was greater than 40% but less than 45%, the atomic composition percentage of nitrogen in the resulting film was approximately 40%, and the atomic composition percentage of carbon was greater than 10% but less than 15%.

The atomic composition percentage of chlorine and oxygen in the resulting film was 0% or greater but less than 5% for each. The wet etch rate of the resulting film by a HF solution was 4.31 A/min.

### Example 3c

A dense SiCN film was deposited using an ALD method with HCDS and 4DMAS precursors. The reaction chamber was controlled at 5 Torr, 550°C, and 55 sccm of Ar was continuously flowing. The deposition process comprised the following steps of: 1) introducing a pulse of approx.1 sccm of 4DMAS into the reaction chamber for 10 seconds, 2) purging the 4DMAS precursor with 55 sccm of Ar for 30 seconds, 3) introducing a pulse of approx.1 sccm of HCDS into the reaction chamber for 10 seconds, and 4) purging the HCDS precursor with 55 sccm of Ar for 30 seconds. Sequences 1) through 4) were repeated until the deposited layer achieved suitable layer thickness.

The deposition rate and the refractive index of the deposited film are shown in **FIG 6****.** The atomic composition percentage of silicon in the resulting film was greater than 50% but less than 55%, the atomic composition percentage of carbon in the resulting film was greater than 30% but less than 35%, and the atomic composition percentage of nitrogen was approximately 10%.

The atomic composition percentage of chlorine and oxygen in the resulting film was 1% or greater but less than 5% for each. The wet etch rate of the resulting film by a HF solution was 0.15 A/min.

### Example 4a

A dense SiCN film was deposited using an ALD method with hexachlorodisilane (HCDS) and bis(diethylamino)silane (BDEAS) precursors and an ammonia (NH₃) reactant. The reaction chamber was controlled at 5 Torr, 550°C, and 55 sccm of Ar was continuously flowing.

The deposition process comprised the following steps of: 1) introducing a pulse of approx.1 sccm of BDEAS into the reaction chamber for 10 seconds, 2) purging the BDEAS precursor with 55 sccm of Ar for 30 seconds, 3) introducing a pulse of approx.1 sccm of HCDS into the reaction chamber for 10 seconds, 4) purging the HCDS precursor with 55 sccm of Ar for 30 seconds, 5) introducing a pulse of approx. 50 sccm of NH₃ into the reaction chamber for 10 seconds, and 6) purging the NH₃ reactant with 55 sccm of Ar for 10 seconds. Sequences 1) through 6) were repeated until the deposited layer achieved suitable layer thickness.

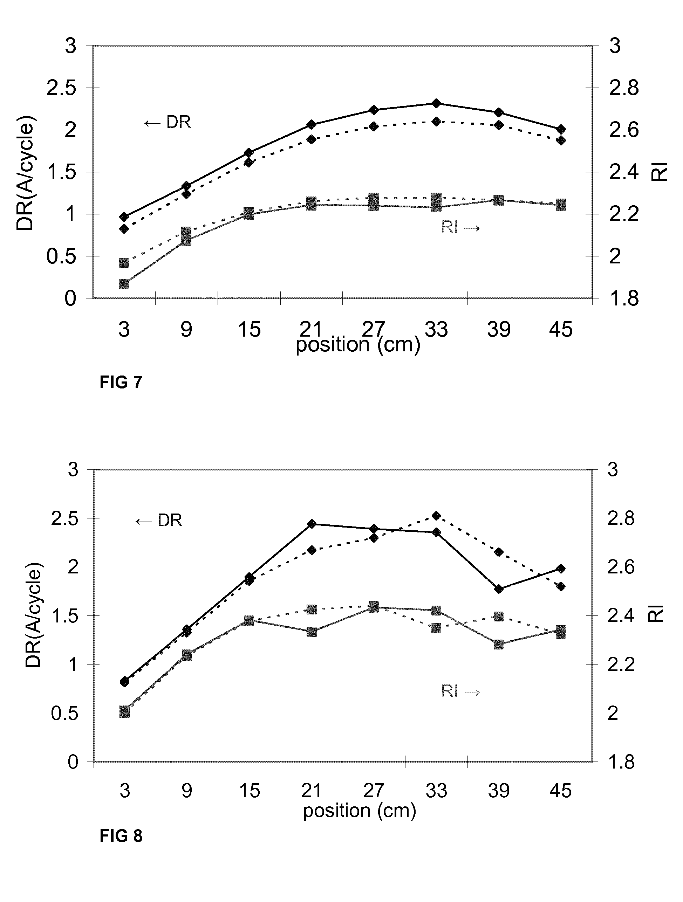

The deposition rate and the refractive index of the deposited film are shown in **FIG 7****.** The atomic composition percentage of silicon in the resulting film was slightly greater than approximately 40%, the atomic composition percentage of nitrogen in the resulting film was slightly less than 40%, and the atomic composition percentage of carbon was slightly greater than 15%.

The atomic composition percentage of chlorine and oxygen in the resulting film was 0% or greater but less than 5% for each. The wet etch rate of the resulting film by a HF solution was 1.65 A/min.

### Example 4b

A dense SiCN film was deposited using an ALD method with HCDS and BDEAS precursors and an ammonia (NH₃) reactant. The reaction chamber was controlled at 5 Torr, 550°C, and 55 sccm of Ar was continuously flowing.

The deposition process comprised the following steps of: 1) introducing a pulse of approx.1 sccm of HCDS into the reaction chamber for 10 seconds, 2) purging the HCDS precursor with 55 sccm of Ar for 30 seconds, 3) introducing a pulse of approx.1 sccm of BDEAS into the reaction chamber for 10 seconds, 4) purging the BDEAS precursor with 55 sccm of Ar for 30 seconds, 5) introducing a pulse of approx. 50 sccm of NH₃ into the reaction chamber for 10 seconds, and 6) purging the NH₃ reactant with 55 sccm of Ar for 10 seconds. Sequences 1) through 6) were repeated until the deposited layer achieved suitable layer thickness.

The deposition rate and the refractive index of the deposited film are shown in **FIG 8****.** The atomic composition percentage of silicon in the resulting film was approximately 45%, the atomic composition percentage of nitrogen in the resulting film was approximately 30%, and the atomic composition percentage of carbon was approximately 20%.

The atomic composition percentage of chlorine and oxygen in the resulting film was 0% or greater but less than 5% for each. The wet etch rate of the resulting film by a HF solution was 0.54 A/min.

### Example 4c

A dense SiCN film was deposited using an ALD method with HCDS and BDEAS precursors. The reaction chamber was controlled at 5 Torr, 550°C, and 55 sccm of Ar was continuously flowing. The deposition process comprised the following steps of: 1) introducing a pulse of approx.1 sccm of BDEAS into the reaction chamber for 10 seconds, 2) purging the BDEAS precursor with 55 sccm of Ar for 30 seconds, 3) introducing a pulse of approx.1 sccm of HCDS into the reaction chamber for 10 seconds, and 4) purging the HCDS precursor with 55 sccm of Ar for 30 seconds. Sequences 1) through 4) were repeated until the deposited layer achieved suitable layer thickness.

The carbon content of the resulting film was too high to allow for the measurement of deposition rate and refractive index by ellipsometry. The atomic composition percentage of silicon in the resulting film was greater than 55% but less than 60%, the atomic composition percentage of carbon in the resulting film was greater than 30% but less than 35%, and the atomic composition percentage of nitrogen was slightly greater than 5%.

The atomic composition percentage of chlorine and oxygen in the resulting film was 0% or greater but less than 5% for each. The wet etch rate of the resulting film by a HF solution was 0.15 A/min.

### Example 5

Applicants believe that dense HfSiCN films will be deposited using the disclosed ALD methods with HfCl₄ and 3DMAS precursors. Applicants believe that the disclosed methods may be used to alter the stoichiometric ratios in the resulting film.

### Example 6

Applicants believe that dense HfSiCN films will be deposited using the disclosed ALD methods with tetrakis(ethylmethylamino)hafnium and HCDS precursors. Applicants believe that the disclosed methods may be used to alter the stoichiometric ratios in the resulting film.

It will be understood that many additional changes in the details, materials, steps, and arrangement of parts, which have been herein described and illustrated in order to explain the nature of the invention, may be made by those skilled in the art within the principle and scope of the invention as expressed in the appended claims.

Thus, the present invention is not intended to be limited to the specific embodiments in the examples given above and/or the attached drawings.

## Claims

1. A method of forming a metal-nitride-containing film, said method comprising the steps of:
a) introducing a halogenated metal precursor into an ALD reactor containing at least one substrate;
b) purging excess halogenated metal precursor from the reactor;
c) introducing an amino-metal precursor into the reactor; and
d) purging excess amino-metal precursor from the reactor,
e) optionally introducing a reactant into the reactor,
f) optionally purging excess reactant from the reactor,
wherein a metal of the halogenated metal precursor and amino-metal precursor is the same or different, and wherein the metal-nitride-containing film is a silicon-nitride-containing film, the halogenated metal precursor is a chlorosilane precursor, and the amino-metal precursor is an aminosilane precursor.

2. The method of claim 1, wherein the reactant is selected from the group consisting of N₂, NH₃, N₂H₄, NMeH₂, NEtH₂, NMe₂H, NEt₂H, NMe₃, NEt₃, MeHNNH₂, Me₂NNH₂, phenyl hydrazine, and mixtures thereof, and preferably is NH₃.

3. The method of claim 1 or 2, wherein the silicon-nitride-containing film is carbon-doped SiN film.

4. The method of any one of claims 1 to 3, wherein the chlorosilane precursors have the formula SiₐH_{b}Cl_{c}, wherein b+c = 2a+2.

5. The method of any one of claims 1 to 4, wherein the chlorosilane precursors are introduced as a mixture.

6. The method of any one of claims 1 to 5, wherein the aminosilane precursors have formula H₄₋ₓSi(NR'R")ₓ, wherein x = 1, 2, 3, or 4, R' and R" are independently selected from H or an alkyl group, and R' and R" may be linked to form a ring structure.

7. The method of claim 6, wherein the aminosilane precursors comprise an aminochlorosilane or an aminoalkylsilane.

8. The method of claim 7, wherein the aminochlorosilane precursors have a formula Cl₄₋ₓSi(NR'R")ₓ, wherein x = 2 or 3 and R' and R" are as previously defined.

9. The method of claim 7, wherein the aminoalkylsilane precursors have a formula R"'₄₋ₓSi(NR'R")ₓ wherein x = 1, 2, or 3, R' and R" are as previously defined, and R'" group is an alkyl group having less than 3 carbons.
